(19) Europäisches Patentamt
European Patent Office
Office européen des brevets

(11) **EP 2 492 934 A2**

(12) **EUROPEAN PATENT APPLICATION**

(43) Date of publication:
**29.08.2012 Bulletin 2012/35**

(51) Int Cl.:
***H01G 9/20*** (2006.01)

(21) Application number: **12155622.9**

(22) Date of filing: **15.02.2012**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br><br>(30) Priority: **22.02.2011 KR 20110015550**<br><br>(71) Applicant: **Samsung SDI Co., Ltd.**<br>**Yongin-si, Gyeonggi-do (KR)** | (72) Inventors:<br>• **Shin, Byong-Cheol**<br>**Gyeonggi-do (KR)**<br>• **Lee, Ji-Won**<br>**Gyeonggi-do (KR)**<br>• **Do, Young-Rag**<br>**Gyeonggi-do (KR)**<br><br>(74) Representative: **Walaski, Jan Filip et al**<br>**Venner Shipley LLP**<br>**200 Aldersgate**<br>**London**<br>**EC1A 4HD (GB)** |

(54) **Dye-sensitized solar cell**

(57)     A dye-sensitized solar cell including: a first substrate and a second substrate positioned to face each other; a first electrode layer on the first substrate and comprising a light absorption layer; a second electrode layer on the second substrate to face the first electrode layer and comprising a catalyst layer; an electrolyte between the first substrate and the second substrate; a first reflection layer on one surface of the second substrate; and a phosphor layer on one surface of the second electrode layer, the first reflection layer, or the second substrate, wherein the first reflection layer has a photonic crystal structure in which a plurality of dielectric substances having different refractive indexes are alternately arranged.

FIG. 2

**Description**

The present invention relates to the structure of a dye-sensitized solar cell.

A variety of research into substitutes for conventional fossil fuels has been conducted to solve an arising energy problem. In particular, a wide range of research into the utilization of natural energy such as wind energy, nuclear energy, solar energy, etc., has been conducted in order to replace oil-based energy sources that will be exhausted in tens of years. A solar cell uses solar energy, which is a virtually unlimited and environmentally friendly resource, unlike other energy sources. Silicon solar cells have been highlighted since 1983 when a silicon (Si) solar cell was first developed.

However, since the manufacturing of such silicon solar cells is expensive, it takes time to commercialize the use of silicon solar cells and it is difficult to increase cell efficiency. To solve these problems, development of a dye-sensitized solar cell requiring relatively small manufacturing costs was considered.

The dye-sensitized solar cell includes a photosensitive dye that absorbs light of a visible ray region and generates an exciton having an electron/hole pair, and a metal oxide that transfers generated electrons.

However, the photosensitive dye is positioned at a part of the dye-sensitized solar cell that may prevent light supplied to the dye-sensitized solar cell from reaching the photosensitive dye. Furthermore, the photosensitive dye absorbs only sunlight in a specific wavelength region, which restricts effective absorption of sunlight.

An aspect of an embodiment of the present invention is directed toward a dye-sensitized solar cell capable of operating more efficiently.

Additional aspects will be set forth in part in the description which follows and, in part, will be apparent from the description, or may be learned by practice of the presented embodiments.

According to one or more embodiments of the present invention, a dye-sensitized solar cell includes: a first substrate and a second substrate positioned to face each other; a first electrode layer on the first substrate and including a light absorption layer; a second electrode layer on the second substrate to face the first electrode layer and including a catalyst layer; an electrolyte between the first substrate and the second substrate; a first reflection layer on one surface of the second substrate; and a phosphor layer on one surface of the second electrode layer, the first reflection layer, the second substrate, wherein the first reflection layer has a photonic crystal structure in which a plurality of dielectric substances having different refractive indexes (indices) are alternately arranged.

The first electrode layer may further include a first electrode, the second electrode layer may further include a second electrode, and the first reflection layer may be between the first electrode and the second electrode, and the phosphor layer may be on another surface of the second electrode or between the first reflection layer and the first electrode.

The phosphor layer may include $SrGa_2S_4$:Eu. The phosphor layer may include $Y_2O_3$:$Er^{3+}$, $Yb^{3+}$.

The phosphor layer may include a phosphor particle obtained by doping a host selected from the group consisting of $Y_2O_3$, $YF_3$, $NaYF_4$, $NaLaF_4$, $LaF_4$, $BaY_2F_8$, $Na_3YGe_2O_7$, and combinations thereof, or a phosphor particle including a material selected from the group consisting of $Er3^+$, $Yb^{3+}$, $Tm^{3+}$, $Ho^{3+}$, $Pr^{3+}$, $Eu^{2+}$, and combinations thereof.

The phosphor layer may include a phosphor selected from the group consisting of $La_2O_2S$:Eu, $(Ba,Sr)_2SiO_4$: Eu, ZnS:(Cu,Al), $Sr_5(PO_4)_3$:Eu, $BaMgAl_{10}O_{17}$:Eu, $BaMg_2Al_{16}O_{27}$:Eu, $Sr_5(PO_4)_3$Cl:Eu, $(Ba,Mg)_3O \cdot 8Al_2O_3$:Eu, ZnO:Zn, $Zn_2SiO_4$:Mn, $Zn_2GeO_4$:Mn, $YVO_4$Eu, $Y_2O_2S$:Eu, $0.5MgF_2 \cdot 3.5MgO \cdot GeO_2$Mn, ZnS:Cu, and $Y_2O_3$:Eu.

The first reflection layer may include a 1-dimensional (1D) photonic crystal structure.

The first reflection layer may include alternately stacked first oxide thin films and second oxide thin films having different refractive indexes. The first oxide thin films may include titanium dioxide ($TiO_2$), and the second oxide thin films may include silicon dioxide ($SiO_2$).

Each of the first oxide thin films and each of the second oxide thin films may have a thickness in a range of about 10 nm to about 800 nm. The thickness of each of the first oxide thin films may be in a range of about 53 nm to about 69 nm, and the thickness of each of the second oxide thin films may be in a range of about 41 nm to about 53 nm. The thickness of each of the first oxide thin films may be about 57 nm, the thickness of each of the second oxide thin films may be about 88 nm, and the first oxide thin films and the second oxide thin films may be stacked nine times, respectively.

The thickness of each of the first oxide thin films may be greater than that of each of the second oxide thin films.

The first reflection layer may reflect light having a wavelength in a range of about 450 nm to about 600 nm. The first reflection layer may reflect light having a wavelength in a range of about 480 nm to about 550 nm.

The light absorption layer may include titanium dioxide ($TiO_2$) particles and a photosensitive dye on the titanium dioxide particles. The photosensitive dye may be di-tetrabutylammonium cis-bis(isothiocyanato)bis(2,2'-bipyridyl-4,4'-dicarboxylato)ruthenium(II) (N719).

The dye-sensitized solar cell may further include: a second reflection layer on the outermost side of the second substrate in an outer direction thereof. The second reflection layer may include a metal selected from the group consisting of Ag, Cu, Al, and combinations thereof, or a silicon material selected from the group consisting of silicon oxide, silicon dioxide, sialon, silicon nitride, silicon oxynitride, silicon carbide, silicon oxycarbide, and combinations thereof.

According to one or more embodiments of the present invention, a dye-sensitized solar cell includes: a first electrode layer including a light absorption layer; a second electrode layer facing the first electrode layer and including a catalyst layer; an electrolyte between the first electrode layer and the second electrode layer; a first reflection layer on one surface of the second electrode layer; and a phosphor layer positioned on one surface of the first reflection layer, wherein the first reflection layer comprises alternately stacked first oxide thin films and second oxide thin films having different refractive indexes.

The phosphor layer may include $SrGa_2S_4$:Eu. The first reflection layer may reflect light having a wavelength in a range of about 480 nm to about 550 nm.

These and/or other aspects will become apparent and more readily appreciated from the following description of the embodiments, taken in conjunction with the accompanying drawings in which:

FIG. 1 is a conceptual diagram for explaining an operation principle of a dye-sensitized solar cell, according to an embodiment of the present invention;

FIG. 2 is a cross-sectional view schematically illustrating a dye-sensitized solar cell, according to an embodiment of the present invention;

FIG. 3 is a schematic graph of the light absorption characteristics of an N719 dye with respect to wavelengths, according to an embodiment of the present invention;

FIG. 4 is a graph of an incident photon to current conversion efficiency of an N719 photosensitive dye with respect to wavelengths, according to an embodiment of the present invention;

FIG. 5 is a cross-sectional view schematically illustrating a first reflection layer of

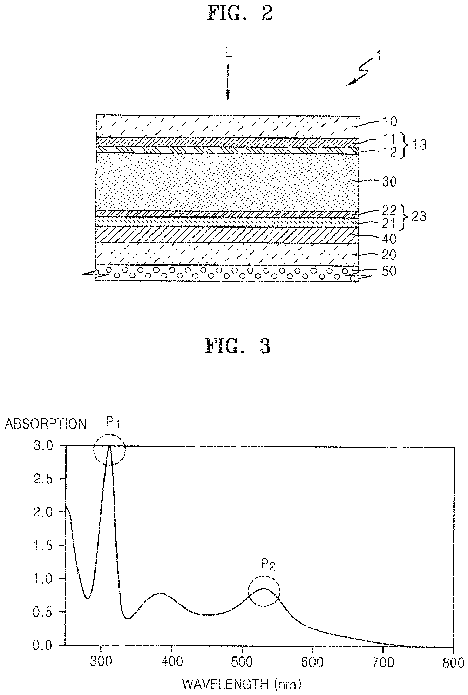

FIG. 2, according to an embodiment of the present invention;

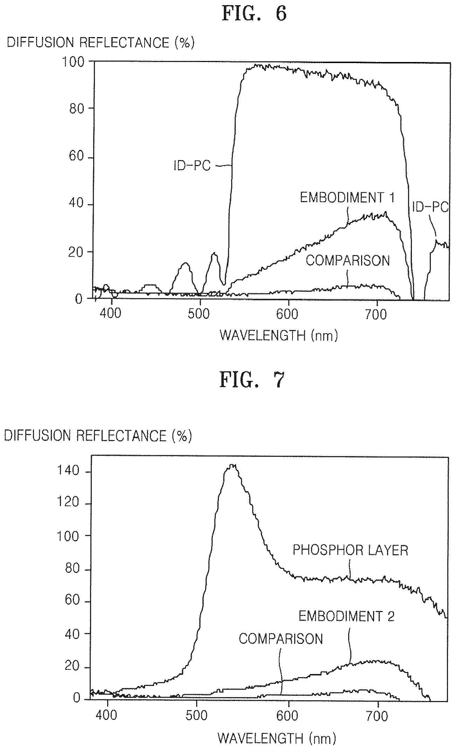

FIG. 6 is a graph illustrating diffusion reflectance of Comparison 1-A, a first reflection layer (labelled as "ID-PC"), and Embodiment 1-A with respect to light wavelengths, according to an embodiment of the present invention;

FIG. 7 is a graph illustrating diffusion reflectance of Comparison 1-A, a phosphor layer including a phosphor of $SrGa_2S_4$:Eu (labelled as "Phosphor Layer"), and Embodiment 2-A with respect to light wavelength, according to an embodiment of the present invention;

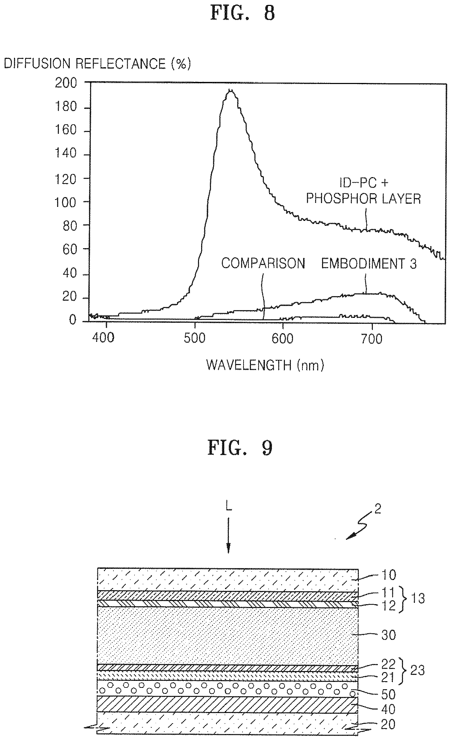

FIG. 8 is a graph illustrating diffusion reflectance of Comparison 1-A, a phosphor layer and a first reflection layer (labelled as "ID-PC + Phosphor Layer"), and Embodiment 3-A with respect to light wavelength, according to an embodiment of the present invention;

FIG. 9 is a cross-sectional view schematically illustrating a dye-sensitized solar cell, according to another embodiment of the present invention; and

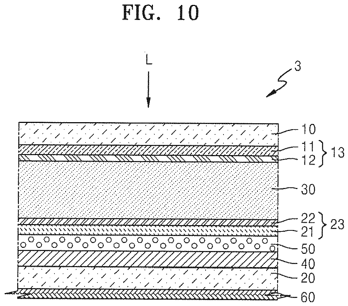

FIG. 10 is a cross-sectional view schematically illustrating a dye-sensitized solar cell, according to another embodiment of the present invention.

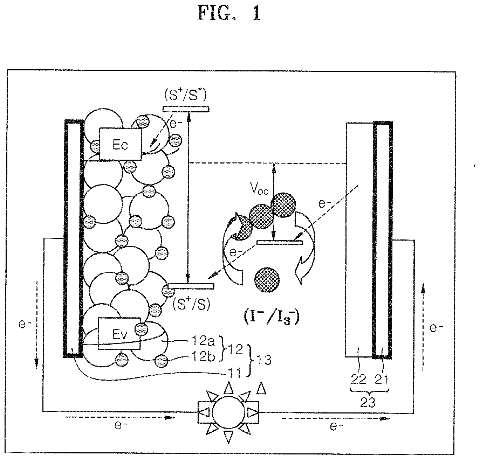

An operation principle of a dye-sensitized solar cell 1 will be described with reference to FIG. 1, and a structure thereof will be described with reference to FIG. 2.

Referring to FIG. 1, when sunlight is absorbed by a photosensitive dye 12a, the photosensitive dye 12a transitions from a ground state to an excited state to form an electron/hole pair (i.e., an exciton). Electrons in the excited state are injected into a conduction band at the interface of the photosensitive dye 12a and minute particles of a porous film 12b. The injected electrons are transferred to a first electrode 11, and move to a second electrode 21 through an external circuit. Meanwhile, the photosensitive dye 12a, oxidized as a result of injecting electrons into the conduction band, is reduced by an iodine redox couple $I_3$-/I-, which is located in an electrolyte layer 30. The oxidized iodine redox couple $I_3$-/I- is reduced by electrons that arrive at the interface of a catalyst layer 22 and a second electrode 21 to achieve charge neutrality, thereby operating the dye-sensitized solar cell 1.

Referring to FIG. 2, the dye-sensitized solar cell 1 may include a first substrate 10, a first electrode layer 13, a second substrate 20, a second electrode layer 23, an electrolyte 30, a first reflection layer 40, and a phosphor layer 50.

The first substrate 10 and the second substrate 20 may be formed of transparent glass and/or polymer. The polymer may include, for example, polyacrylate, polyethylene ether phthalate, polyethylene naphthalate, polycarbonate, polyarylate, polyetherimide, polyethersulfone, and/or polyimide.

The first electrode layer 13 may include the first electrode 11 and a light absorption layer 12. The second electrode layer 23 may include the second electrode 21 and the catalyst layer 22. In this regard, the first electrode 11 and the second electrode 21 may include a transparent conductor. For example, the first electrode 11 and the second electrode 21 may include an inorganic conductive material such as indium tin oxide (ITO), fluorine doped tin oxide (FTO), or antimony doped tin oxide (ATO), or an organic conductive material such as polyacetylene or polythiophene.

The catalyst layer 22 is a catalyst electrode that activates a redox couple, and may include, for example, Pt, Au, Ni, Cu, Ag, In, Ru, Pd, Rh, IR, Os, C, a conductive polymer or combinations thereof. For the purpose of increasing a redox catalyst effect, the surface area of the catalyst layer 22 facing the first electrode 11 may be increased by the presence of fine structure. For example, if the catalyst layer 22 is formed of platinum, the catalyst layer 22 may include platinum black, and if the catalyst layer 22 is formed of carbon, the catalyst layer 22 may include porous carbon. Platinum black may be formed by using a positive electrode oxidation method, platinum chloride processing, etc. Porous carbon may be formed by sintering minute carbon particles, baking an organic polymer, etc.

The light absorption layer 12 may include the photosensitive dye 12a and the porous film 12b, which adsorbs the photosensitive dye 12a (e.g., the photosensitive dye 12a may be included in or on the porous film 12b). The photosensitive dye 12a will be described in more detail below. The porous film 12b may have a uniform distribution of minute particles having fine and uniform nano sized average diameters, maintain porosity, and have an appropriate surface toughness. The porous film 12b may include, for example, $TiO_2$, $SnO_2$, ZnO, $WO_3$, $Nb_2O_5$, $TiSrO_3$ or a compound thereof.

The porous film 12b may increase the surface area of the photosensitive dye 12a so that the photosensitive dye 12a, which is adsorbed onto the surface of the porous film 12b, may absorb more light. Thus, particles of the porous film 12b may have minute average particle diameters in a range of about 5 nm to about 50 nm. However, the average particle diameters of the particles are exemplary, and certain embodiments of the present invention are not limited thereto. The particles of the porous film 12b, having average particle diameters within the above range, are adhered to the photosensitive dye 12a during thermal processing, after the porous film 12b is formed, thereby increasing the amount of light adsorption of the photosensitive dye 12a by increasing the surface area of the photosensitive dye 12a.

The electrolyte 30 may include a material used to promote a redox reaction of a redox couple, and may be a liquid electrolyte or a solid polymer electrolyte. A solution in which, for example, lithium salt such as LiOH or LiClO4, potassium salt such as KOH, sodium salt such as NaOH, etc. are dissolved in a solvent, may be used as the liquid electrolyte. However, certain embodiments of the present invention are not limited thereto. Poly(2-acrylamino-2-methylpropane sulfonic acid) or poly(ethylene oxide) may be used as the solid polymer electrolyte. However, certain embodiments of the present invention are not limited thereto.

The photosensitive dye 12a will now be described in more detail. The photosensitive dye 12a may include a variety of materials. For example, the photosensitive dye 12a may include a metal composite including aluminum (Al), platinum (Pt), palladium (Pd), europium (Eu), lead (Pb), iridium (Ir), ruthenium (Ru), etc. Furthermore, a dye including an organic pigment, etc. may be used as the photosensitive dye 12a. The organic pigment may include coumarin, porphyrin, xanthene, riboflavin, triphenylmethane, etc. These organic pigments may be independently used or mixed with a ruthenium (Ru) composite, which improves absorption of visible light having a long wavelength, thereby further increasing photoelectric conversion efficiency. In this regard, the photosensitive dye 12a absorbs sunlight having a wavelength in a range of about 400 nm to about 800 nm, more specifically in a range of about 400 nm to about 650 nm, and exhibits excellent light to current conversion efficiency.

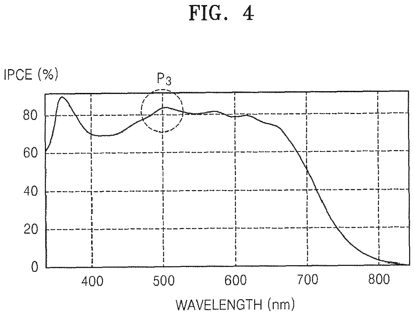

An N719 dye (i.e., di-tetrabutylammonium cis-bis(isothiocyanato)bis(2,2'-bipyridyl-4,4'-dicarboxylato)ruthenium(II)), developed by Gratzel Laboratory, is most commonly used among ruthenium complex compounds. The light absorption characteristics of the N719 dye will be described with reference to FIG. 3. FIG. 3 is a schematic graph of the light absorption characteristics of the N719 dye with respect to wavelengths of light (nm). The N719 dye has different absorption spectrums with respect to different wavelengths of light. Although the N719 dye absorbs the most sunlight at a region P1 having a wavelength of about 300 nm, sunlight incident through the atmosphere of the Earth does not have a wavelength below about 300 nm. Thus, the spectrum absorbed by the N719 dye at a region having a wavelength greater than about 300 nm is high at a region P2 having a wavelength in a range of about 450 nm to about 600 nm. The N719 dye absorbs the most sunlight at a wavelength in a range of about 480 nm to about 550 nm. FIG. 4 is a graph appearing in Inorganic Chemistry, Vol. 44, No. 20, 2005 (Michael Grätzel) indicating the relationship of an incident photon to current conversion efficiency (IPCE) (i.e., electron efficiency) when the N719 photosensitive dye 12a absorbs sunlight, with respect to wavelengths of light. Referring to FIG. 4, the IPCE is high in a region P3 having a wavelength of light in a range of about 450 nm to about 600 nm, more specifically in a range of about 480 nm to about 550 nm. Thus, to increase efficiency of the dye-sensitized solar cell 1, the dye-sensitized solar cell 1 may absorb a greater amount of light by reflecting light passing through the dye-sensitized solar cell 1. Furthermore, if the reflected light has a wavelength in a range of about 450 nm to about 600 nm or in a range of about 480 nm to about 550 nm, the light current density increases, thereby increasing efficiency of the dye-sensitized solar cell 1.

The dye-sensitized solar cell 1 may include the first reflection layer 40 and the phosphor layer 50 to allow the reflected light to have a wavelength in a range of about 450 nm to about 600 nm or in a range of about 480 nm to about 550 nm.

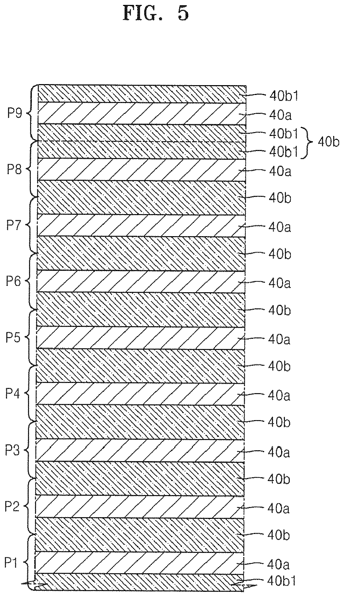

The first reflection layer 40 will now be described in more detail with reference to FIG. 5. The first reflection layer 40 may have a photonic crystal structure. The photonic crystal structure may block or reflect light having a specific wavelength band by periodically combining materials having different dielectric constants. The selection of the wavelength band may be changed by changing the material or the structure of the photonic crystal. The photonic band gap may be adjusted by changing the type of the material without changing the structure of the material or by changing the structure of the material without changing the type of the material. This is advantageous in terms of making processing changes, since the structure can be changed, without changing the material, to select another wavelength. The first reflection layer 40 may have a reflectivity of 100% with respect to a specific wavelength by using the photonic crystal.

The photonic crystal may be configured 1-dimensionally, 2-dimensionally, or 3-dimensionally. The dye-sensitized solar cell 1 may include the first reflection layer 40 as a 1-dimensional photonic crystal (ID PC). That is, the ID PC may be manufactured by periodically stacking two or more different materials having different dielectric constants (or refractive indexes). In this regard, a photonic band gap is generated with respect to a wavelength of light travelling in the direction of the stacking, i.e., a wavelength of light travelling in a direction perpendicular to each layer. The photonic band gap may be used as the first reflection layer 40. The photonic band gap is generated with respect to another wavelength of light if the stacking structure (e.g., the thickness of each layer, etc.) is changed. Thus, the first reflection layer 40 may have characteristics close to 100% reflectivity with respect to incident light by using appropriate thickness and period.

FIG. 5 is a cross-sectional view schematically illustrating the first reflection layer 40 of FIG. 2, according to an embodiment of the present invention. Referring to FIG. 5, the first reflection layer 40 may reflect light having a wavelength in a range of about 380 nm to about 700 nm. In this regard, the first reflection layer 40 may be configured to allow the first reflection layer 40 to reflect light having a wavelength in a range of about 450 nm to about 600 nm or in a range of about 480 nm to about 550 nm, in consideration of the light absorption characteristics of the N719 dye. The first reflection layer 40 may be configured by alternately stacking a plurality of first oxide thin films 40a and second oxide thin films 40b having different refractive indexes. One of the first oxide thin film 40a and the second oxide thin film 40b may have a high refractive index, and the other may have a low refractive index. For example, the first oxide thin film 40a may have a high refractive index, and the second oxide thin film 40b may have a low refractive index. In this regard, the first oxide thin film 40a may include titanium dioxide ($TiO_2$), and the second oxide thin film 40b may include silicon dioxide ($SiO_2$).

When N first oxide thin films 40a and second oxide thin films 40b are stacked, the wavelength of light reflected by the first reflection layer 40 can be selected according to the thickness of each layer. Thus, a reflection wavelength region may be selected by adjusting the thickness according to the wavelength region to be reflected. For example, reflection of a specific wavelength region may be maximized or increased by determining the thicknesses of the first oxide thin film 40a and the second oxide thin film 40b according to equations 1 and 2 below,

$$\mathit{Equation\ 1}$$
$$\text{thickness}(t_1) = \lambda/4n_1$$

$$\mathit{Equation\ 2}$$
$$\text{thickness}(t_2) = \lambda/4n_2$$

wherein, $n_1$ denotes the refractive index of the first oxide thin film 40a, e.g., titanium dioxide ($TiO_2$), $n_2$ denotes the refractive index of the second oxide thin film 40b, e.g., silicon dioxide ($SiO_2$), $\lambda$ denotes the specific wavelength region, $t_1$ denotes the thickness of the first oxide thin film 40a, e.g., titanium dioxide ($TiO_2$), and $t_2$ denotes the thickness of the second oxide thin film 40b, e.g., silicon dioxide ($SiO_2$).

The first reflection layer 40 may include a plurality of oxide layer pairs P1, P2, ..., P9. The first oxide layer pair P1 may be formed by positioning unit second oxide thin films 40b1 on two surfaces of the first oxide thin films 40a. Referring to FIG. 5, two unit second oxide thin films 40b1 may form one second oxide thin film 40b. In this regard, although the unit second oxide thin films 40b1 that are separated into two are disposed between the first oxide thin films 40a, the two unit second oxide thin films 40b1 may form the one second oxide thin film 40b. In this regard, the unit second oxide thin films 40b1 may be positioned at both ends of the stacked first oxide thin films 40a. The thickness of the second oxide thin film 40b may be twice the thickness of the unit second oxide thin film 40b1. In the present embodiment, the oxide layer pairs P1, P2, ..., P9 are stacked nine times.

For example, the first oxide thin film 40a includes titanium dioxide (TiO2) and has a thickness of 61 nm (or about 61 nm). The second oxide thin film 40b includes silicon dioxide (SiO2) and has a thickness of 94 nm (or about 94 nm). When the oxide layer pairs P1, P2, ..., P9 are stacked nine times, the reflectivity may be close to 100% at a wavelength of light in range of about 480 nm to about 650 nm.

In certain embodiments, the first oxide thin film 40a includes titanium dioxide (TiO2) and has a thickness of 57 nm (or about 57 nm). The second oxide thin film 40b includes silicon dioxide (SiO2) and has a thickness of 88 nm (or about 88 nm). When the oxide layer pairs P1, P2, ..., P9 are stacked nine times, the reflectivity may be close to 100% at a wavelength of light in a range of about 450 nm to about 600 nm.

In other embodiments, the first oxide thin film 40a includes titanium dioxide ($TiO_2$) and has a thickness of 53 nm (or about 53 nm). The second oxide thin film 40b includes silicon dioxide ($SiO_2$) and has a thickness of 41 nm (or about 41 nm). In one embodiment, when the oxide layer pairs P1, P2, ..., P9 are stacked nine times, the reflectivity is close to 100% at a wavelength of light in a range of about 400 nm to about 550 nm.

Thus, the reflectivity may be controlled to be highest at a specific wavelength of light by adjusting the thicknesses of the first oxide thin films 40a and the second oxide thin films 40b, a plurality of which are stacked and have different refractive indexes.

According to embodiments of the present invention, the first oxide thin film 40a includes titanium dioxide ($TiO_2$). The second oxide thin film 40b includes silicon dioxide ($SiO_2$). The first oxide thin film 40a may have a thickness in a range of about 53 nm to about 69 nm. The second oxide thin film 40b may have a thickness in a range of about 41 nm to about 53 nm. In this regard, the first reflection layer 40 may reflect light having a wavelength in a range of about 450 nm to about 600 nm, more specifically, in a range of about 480 nm to about 550 nm.

Therefore, if the photosensitive dye 12a is N719, the amount of light absorbed by the photosensitive dye 12a may be increased by adjusting the wavelength of light reflected by the first reflection layer 40 to a range of about 480 nm to about 550 nm.

If the first oxide thin film 40a is a high refractive index thin film, the thickness of the first oxide thin film 40a may be greater than that of the second oxide thin film 40b.

As described above, the first reflection layer 40 may be used to increase the amount of light absorbed by the photosensitive dye 12a by reflecting light that is not absorbed by the photosensitive dye 12a of the light absorption layer 12 and sending the reflected light back to the light absorption layer 12. Furthermore, the light current density and the IPCE may be increased by reflecting light having a specific wavelength using the first reflection layer 40. Thus, the efficiency of the dye-sensitized solar cell 1 may be improved.

The phosphor layer 50 will now be described in more detail. As described above, the photosensitive dye 12a exhibits maximum light current efficiency at a wavelength of sunlight in a range of about 450 nm to about 600 nm, and N719 dye exhibits maximum light current efficiency at a wavelength of sunlight in a range of about 480 nm to about 550 nm. Thus, the phosphor layer 50 of the dye-sensitized solar cell 1 may greatly increase power generation efficiency of the solar cell by converting light in the infrared region to absorbable visible light C1 (down conversion) or converting light in the ultraviolet region into visible light C2 (up conversion). Non-limiting examples of up conversion phosphor particles include $Y_2O_3{:}Er^{3+}$, $Yb_{3+}$; $YF_3{:}Yb^{3+}$, $Er^{3+}$; $NaYF_4{:}Yb^{3+}$, $Er^{3+}$; $NaLaF_4{:}Yb^{3+}$, $Er^{3+}$; $LaF_4{:}Yb^{3+}$, $Er^{3+}$; $BaY_2F_8{:}Yb^{3+}$, $Er^{3+}$; and $Na_3YGe_2O_7{:}Yb^{3+} Er^{3+}$ In this regard, for example, $Y_2O_3{:}Er^{3+}$, $Yb^{3+}$ may have a peak emission in a region of light having a wavelength in a range of about 550 nm to about 650 nm. If N719 is used as the photosensitive dye 12a, the photosensitive dye 12a exhibits maximum light efficiency at a wavelength of light in a range of about 450 nm to about 600 nm or in a range of about 480 nm to about 550 nm. Thus, the photosensitive dye 12a may exhibit maximum light current efficiency by absorbing light emitted from $Y_2O_3{:}Er^{3+}$, $Yb^{3+}$ having peak emission in the region of light having a wavelength of 550 nm (or about 550 nm). In this regard, when Er is 10 wt%, a peak value of about 550 nm may be at a maximum intensity. When Er is 10 wt% in $Y_2O_3{:}Er^{3+}$, $Yb^{3+}$; the greater the wt% of $Yb^{3+}$, the lower the maximum intensity of light having a wavelength of 550 nm (or about 550 nm), and the higher the maximum intensity of light having a wavelength of 650 nm (or about 650 nm). Therefore, as the wt% of $Y^{b3+}$ decreases, the maximum intensity of light having a wavelength of 550 nm emitted from the $Y_2O_3 Er^{3+}$, $Yb^{3+}$ phosphor particle increases, and the maximum intensity of light having a wavelength of 550 nm reaching the photosensitive dye 12a increases. A phosphor including lithium salt in an amount of 5 wt% (or about 5 wt%) has a light intensity about 1.5 times higher than that of a phosphor excluding the lithium salt. Thus, in one embodiment, if the lithium salt of about 5 wt% is included in the phosphor, the emission of light having a peak value of 550 nm increases, and the intensity of light having a wavelength of 550 nm reaching the photosensitive dye 12a also increases, thereby increasing the light current efficiency.

Non-limiting examples of down conversion phosphor particles used in the present embodiment include $(Sr,Ba,Ca)_2Si_sN_8{:}Eu^{2+}$; $CaAlSiN_3{:}Eu^{2+}$; $BaMgAl_{10}O_{17}{:}Eu^{2+}$; $BaMgAl_{10}O_{17}{:}Eu^{2+}$,$Mn^{2+}$; $SiAlON{:}Eu^{2+}$; $(Ca,Sr,Ba)_2P_2O_7{:}Eu^{2+}$; $(Ca,Sr,Ba)_2P_2O_7{:}Eu^{2+}$, $Mn^{2+}$; $(Ca,Sr,Ba)_5(PO_4)_3Cl{:}Eu^{2+}$; $Lu_2SiO_5{:}Ce^{3+}$; $(Ca,Sr,Ba)_3SiO_5{:}Eu^{2+}$; $(Ca,Sr,Ba)_2SiO_4{:}Eu^{2+}$; $(Ca,Sr,Ba)_{10}(PO_4)_6 \cdot nB_2O_3{:}Eu^{2+}$; $Sr_4Al_{14}O_{25}{:}Eu^{2+}$; and $3.5MgO \cdot 0.5MgF_2.GeO_2{:}Mn^{4+}$. The dye-sensitized solar cell 1 may easily use sunlight by using the phosphor layer 50.

A visible ray of sunlight incident onto the first electrode 11 of the first electrode layer 13 may be partially absorbed by the photosensitive dye 12a of the light absorption layer 12, and the visible ray that is not absorbed may be reflected or diffused by the first reflection layer 40 or the phosphor layer 50 and absorbed by the photosensitive dye 12a.

The phosphor included in the phosphor layer 50 may include an inorganic material that produces suitable light-emitting and phosphorescent phenomena and that emits light having a wavelength in a range of about 400 nm to 650 nm, which is absorbed by the dye-sensitized solar cell 1. For example, the phosphor layer may include a phosphor selected from the group consisting of $SrGa_2S_4{:}Eu$, $La_2O_2S{:}Eu$, $(Ba,Sr)_2SiO_4Eu$, $ZnS{:}(Cu,Al)$, $Sr_5(PO_4)_3{:}Eu$, $BaMgAl_{10}O_{17}{:}Eu$, $BaMg_2Al_{16}O_{27}{:}Eu$, $Sr_5(PO_4)_3Cl{:}Eu$, $(Ba,Mg)_3O \cdot 8Al_2O_3{:}Eu$, $ZnO{:}Zn$, $Zn_2SiO_4{:}Mn$, $Zn_2GeO_4{:}Mn$, $YVO_4Eu$, $Y_2O_2S{:}Eu$, $0.5MgF_2 3.5MgO \cdot GeO_2{:}Mn$, $ZnS{:}Cu$, $Y_2O_3{:}Eu$, and $BaMgAl_{10}O_{17}{:}Eu$, but is not limited thereto.

Among these phosphors, the phosphor may include $SrGa_2S_4$:Eu. That is, $SrGa_2S_4$:Eu emits light at a wavelength in a range of about 490 nm to about 600 nm, and has a peak emission at a wavelength of about 535 nm. Thus, when the photosensitive dye 12a is an N719 dye, if the phosphor layer 50 includes $SrGa_2S_4$:Eu, efficiency may increase.

Furthermore, the phosphor may include a phosphor particle obtained by doping a host selected from the group consisting of $YF_3$, $NaYF_4$, $NaLaF_4$, $LaF_4$, $BaY_2F_8$, and $Na_3YGe_2O_7$, or a phosphor particle including a material selected from the group consisting of $Er^{3+}$, $Yb^{3+}$, $Tm^{3+}$, $Ho^{3+}$, $Pr^{3+}$, $Eu^{3+}$, and combinations thereof.

The phosphor layer 50 included in the dye-sensitized solar cell 1 of embodiments of the present invention may be formed by mixing a binder and an organic solvent, forming a phosphor paste, coating the phosphor paste through screen printing, and baking the resultant coating. A thickness of the phosphor layer 50 may be in a range of about 10 $\mu$m to about 50 $\mu$m, in terms of the particle diameter of the phosphor, to prevent or protect from a penetration loss of sunlight.

Comparison 1

The light absorption layer 12 of Comparison 1 is manufactured by using titanium dioxide ($TiO_2$) particles having diameters of 20 nm. An organic substance remaining on the light absorption layer 12 is removed by thermally treating the manufactured porous titanium dioxide film at a temperature of 500°C for 30 minutes, and the titanium dioxide particles are sintered. N719, (i.e., the photosensitive dye 12a) is adsorbed in (i.e., on) the light absorption layer 12, and then the dye-sensitized solar cell 1 is manufactured.

Embodiment 1

In Comparison 1 above, the first electrode 11, on which the light absorption layer 12 that adsorbs the photosensitive dye 12a is positioned, is not deformed. In Embodiment 1 the first reflection layer 40 is positioned between the second electrode 21 and the second substrate 20. In this regard, the first reflection layer 40 has a 1D photonic crystal structure in which a specific wavelength is reflected by stacking the first oxide thin films 40a and the second oxide thin films 40b. The first oxide thin films 40a may include titanium dioxide ($TiO_2$). The second oxide thin films 40b may include silicon dioxide ($SiO_2$).

In this regard, titanium dioxide ($TiO_2$) of 57 nm and silicon dioxide ($SiO_2$) of 44 nm are repeatedly stacked nine times. Thus, referring to FIG. 5, the thicknesses of the unit second oxide thin films 40b1 may be 44 nm, and the thicknesses of the first oxide thin films 40a may be 57 nm, and the thicknesses of the second oxide thin films 40b may be 88 nm.

Embodiment 2

In Embodiment 2, the phosphor layer 50 may be positioned at an outer side of the second substrate 20. The phosphor layer 50 may include $SrGa_2S_4$:Eu as a phosphor.

Embodiment 3

In Embodiment 3, the first reflection layer 40 is positioned on a surface of the second electrode 20, and the phosphor layer 50 may be positioned at an outer side of the second substrate 20. A structure of Embodiment 3 may be the same as that of FIG. 2.

Effect

Each experiment was carried out twice. Experimental results for Comparisons 1-A and 1-B and Embodiments 1-A, 2-A, 3-A, 1-B, 2-B, and 3-B are shown in Table 1 below. FIG. 6 is a graph illustrating diffusion reflectance for Comparison 1-A, the first reflection layer 40 (labeled as "ID-PC"), and Embodiment 1-A with respect to light wavelength, according to an embodiment of the present invention. FIG. 7 is a graph illustrating diffusion reflectance of Comparison 1-A, the phosphor layer 50 including a phosphor of $SrGa_2S_4$:Eu (labelled as "Phosphor Layer"), and Embodiment 2-A with respect to light wavelength, according to an embodiment of the present invention. FIG. 8 is a graph illustrating diffusion reflectance of Comparison 1-A, the phosphor layer 50 and the first reflection layer 40 (labeled as "ID-PC + Phosphor Layer"), and Embodiment 3-A with respect to light wavelength, according to an embodiment of the present invention.

Table 1

| Remarks | Voc(V) | Jsc(mA/cm²) | FF | Efficiency (%) |
|---|---|---|---|---|
| Comparison 1-A | 0.75 | 12.70 | 72 | 6.9 |
| Embodiment 1-A | 0.75 | 13.83 | 73 | 7.5 |
| Embodiment 2-A | 0.75 | 14.44 | 72 | 7.8 |
| Embodiment 3-A | 0.75 | 14.49 | 72 | 7.9 |
| Comparison 1-B | 0.74 | 13.75 | 69 | 7.0 |
| Embodiment 1-B | 0.74 | 14.94 | 69 | 7.6 |
| Embodiment 2-B | 0.74 | 15.40 | 69 | 7.8 |
| Embodiment 3-B | 0.74 | 15.55 | 68 | 7.9 |

The experimental results will now be described with reference to Table 1 and FIGS. 6 through 8. In this regard, Comparisons 1-A and 1-B relate to a conventional dye-sensitized solar cell including the N719 photosensitive dye 12a. Embodiments 1-A and 1-B relate to the first reflection layer 40 of a ID photonic crystal structure, in addition to the features of Comparisons 1-A and 1-B. Embodiments 2-A and 2-B relate to the phosphor layer 50 including the phosphor $SrGa_2S_4$: Eu, in addition to the features of Comparisons 1-A and 1-B. Embodiments 3-A and 3-B relate to the phosphor layer 50 including the phosphor $SrGa_2S_4$:Eu and the first reflection layer 40 of the ID photonic crystal structure, in addition to the features of Comparisons 1-A and 1-B.

In Table 1, among Comparison 1-A and Embodiments 1-A, 2-A, and 3-A, Embodiment 3-A has the highest efficiency of 7.9%, which is increased by about 15% as compared to the 6.9% efficiency of Comparison 1-A. Among Comparison 1-B and Embodiments 1-B, 2-B, and 3-B, Embodiment 3-B has the highest efficiency of 7.9%, which is increased by about 13% as compared to the efficiency of Comparison 1-B.

Referring to FIG. 6, the diffusion reflectance of the first reflection layer 40 may be close to 100% in a region of light having a wavelength of around 550 nm. Referring to FIG. 7, the diffusion reflectance of the phosphor layer 50 including the phosphor $SrGa_2S_4$:Eu is 140% in the region of light having a wavelength around 550 nm. Referring to FIG. 8, when the first reflection layer 40 and the phosphor layer 50 including the phosphor $SrGa_2S_4$:Eu are both used, the diffusion reflectance is 200% in the region of light having a wavelength of about 550 nm.

The position of the phosphor layer 50 will now be described in more detail with reference to FIG. 9. FIG. 9 is a cross-sectional view schematically illustrating a dye-sensitized solar cell 2, according to another embodiment of the present invention. Referring to FIG. 9, the phosphor layer 50 may be positioned between the second electrode 21 and the first reflection layer 40. The phosphor layer 50 may be formed on the first reflection layer 40 through any suitable process, such as deposition, etc.

As shown in FIG. 10, a second reflection layer 60 may be positioned on an outer side of the second substrate 20. FIG. 10 is a cross-sectional view schematically illustrating a dye-sensitized solar cell 3, according to another embodiment of the present invention. The dye-sensitized solar cell 3 may further include the second reflection layer 60 on the rear surface of the second substrate 20. In this regard, the second reflection layer 60 may be positioned on the outermost side of the second substrate 20 in an outer direction of the second substrate 20.

The second reflection layer 60 may further prevent or reduce a loss of externally discharged sunlight. The second reflection layer 60 may include a material having general reflectivity, such as a metal selected from the group consisting of Ag, Cu, A1, etc., or a silicon material selected from the group consisting of silicon oxide, silicon dioxide, sialon, silicon nitride, silicon oxynitride, silicon carbide, and silicon oxycarbide. These materials may be formed by using suitable deposition processes, such as sputtering.

In Table 1 above, dye-sensitized solar cells according to Embodiments 1 through 3 have improved light current efficiency and efficiency compared to the dye-sensitized solar cell according to Comparison 1. Embodiment 3 produces the best results among Embodiments 1 through 3. The dye-sensitized solar cell according to Embodiment 3 includes the first reflection layer 40 and the phosphor layer 50, and thus the light absorption layer 12 absorbs light reflected by the first reflection layer 40 and light emitted by the phosphor layer 50. Thus, the efficiency of the dye-sensitized solar cell 1 is improved by having an increased amount of light reach the light absorption layer 12.

While the present invention has been described in connection with certain exemplary embodiments, it is to be understood that the invention is not limited to the disclosed embodiments, but, on the contrary, is intended to cover various modifications and equivalent arrangements included within the scope of the appended claims.

**Claims**

1. A dye-sensitized solar cell comprising:

   a first substrate and a second substrate positioned to face each other;
   a first electrode layer on the first substrate and comprising a light absorption layer;
   a second electrode layer on the second substrate to face the first electrode layer and comprising a catalyst layer;
   an electrolyte between the first substrate and the second substrate;
   a first reflection layer on one surface of the second substrate; and
   a phosphor layer on one surface of the second electrode layer, the first reflection layer, or the second substrate, wherein the first reflection layer has a photonic crystal structure in which a plurality of dielectric substances having different refractive indexes are alternately arranged.

2. The dye-sensitized solar cell of claim 1, wherein the first electrode layer further comprises a first electrode, the second electrode layer further comprises a second electrode, and the first reflection layer is between the first electrode and the second electrode, and
   wherein the phosphor layer is on another surface of the second electrode; or
   wherein the phosphor layer is between the first reflection layer and the first electrode.

3. The dye-sensitized solar cell of claim 1 or 2, wherein the phosphor layer comprises $SrGa_2S_4$:Eu or the phosphor layer comprises $Y_2O_3Er^{3+}$, $Yb^{3+}$.

4. The dye-sensitized solar cell of claim 1 or 2, wherein the phosphor layer comprises a phosphor particle obtained by doping a host selected from the group consisting of $Y_2O_3$, $YF_3$, $NaYF_4$, $NaLaF_4$, $LaF_4$, $BaY_2F_8$, $Na_3YGe_2O_7$, and combinations thereof, or a phosphor particle comprising a material selected from the group consisting of $Er^{3+}$, $Yb^{3+}$, $Tm^{3+}$, $Ho^{3+}$, $Pr^{3+}$, $Eu^{3+}$, and combinations thereof.

5. The dye-sensitized solar cell of claim 1 or 2, wherein the phosphor layer comprises a phosphor selected from the group consisting of $La_2O_2S$:Eu, $(Ba,Sr)_2SiO_4$:Eu, ZnS:(Cu,Al), $Sr_5(PO_4)_3$:Eu, $BaMgAl_{10}O_{17}$:Eu, $BaMg_2Al_{16}O_{27}$:Eu, $Sr_5(PO_4)_3Cl$:Eu, $(Ba,Mg)_3O \cdot 8Al_2O_3$:Eu, ZnO:Zn, $Zn_2SiO_4$:Mn, $Zn_2GeO_4$:Mn, $YVO_4$:Eu, $Y_2O_2S$:Eu, $0.5MgF_2 \cdot 3.5MgO \cdot GeO_2$:Mn, ZnS:Cu, and $Y_2O_3$:Eu.

6. The dye-sensitized solar cell of any one of the preceding claims, wherein the first reflection layer comprises a 1-dimensional (1D) photonic crystal structure.

7. The dye-sensitized solar cell of claim 6, wherein the first reflection layer comprises alternately stacked first oxide thin films and second oxide thin films having different refractive indexes.

8. The dye-sensitized solar cell of claim 7, wherein the first oxide thin films comprise titanium dioxide ($TiO_2$), and the second oxide thin films comprise silicon dioxide ($SiO_2$).

9. The dye-sensitized solar cell of claim 7 or 8, wherein each of the first oxide thin films and each of the second oxide thin films have a thickness in the range of about 10 nm to about 800 nm.

10. The dye-sensitized solar cell of claim 9, wherein the thickness of each of the first oxide thin films is in the range of about 53 nm to about 69 nm, and the thickness of each of the second oxide thin films is in the range of about 41 nm to about 53 nm.

11. The dye-sensitized solar cell of claim 9, wherein the thickness of each of the first oxide thin films is about 57 nm, the thickness of each of the second oxide thin films is about 88 nm, and the first oxide thin films and the second oxide thin films are stacked nine times, respectively.

12. The dye-sensitized solar cell of any one of claims 8 to 11, wherein the thickness of each of the first oxide thin films is greater than that of each of the second oxide thin films.

13. The dye-sensitized solar cell of any one of the preceding claims, wherein the first reflection layer is arranged to reflect light having a wavelength in a range of about 450 nm to about 600 nm, or is arranged to reflect light having a wavelength in a range of about 480 nm to about 550 nm.

**14.** The dye-sensitized solar cell of any one of the preceding claims, wherein the light absorption layer comprises titanium dioxide ($TiO_2$) particles and a photosensitive dye on the titanium dioxide particles, wherein the photosensitive dye may comprise di-tetrabutylammonium cis-bis(isothiocyanato)bis(2,2'-bipyridyl-4,4'-dicarboxylato)ruthenium(II) (N719).

**15.** The dye-sensitized solar cell of any one of the preceding claims, further comprising: a second reflection layer on the outermost side of the second substrate in an outer direction thereof, wherein the second reflection layer may comprise a metal selected from the group consisting of Ag, Cu, Al, and combinations thereof, or a silicon material selected from the group consisting of silicon oxide, silicon dioxide, sialon, silicon nitride, silicon oxynitride, silicon carbide, silicon oxycarbide, and combinations thereof.

FIG. 1

# FIG. 2

# FIG. 3

FIG. 4

FIG. 5

## FIG. 6

DIFFUSION REFLECTANCE (%)

WAVELENGTH (nm)

## FIG. 7

DIFFUSION REFLECTANCE (%)

WAVELENGTH (nm)

## FIG. 8

DIFFUSION REFLECTANCE (%)

WAVELENGTH (nm)

## FIG. 9

FIG. 10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **MICHAEL GRÄTZEL.** *Inorganic Chemistry,* 2005, vol. 44 (20